(19) Europäisches Patentamt
European Patent Office
Office européen des brevets

(11) Publication number: 0 138 209 B1

# (12) EUROPEAN PATENT SPECIFICATION

(45) Date of publication of patent specification: 17.01.90

(51) Int. Cl.$^5$: C 08 L 63/00, C 08 G 59/40, C 08 G 59/50, C 08 K 9/06

(21) Application number: 84112269.0

(22) Date of filing: 12.10.84

## (54) Epoxy resin composition.

(30) Priority: 14.10.83 JP 190756/83
13.07.84 JP 144240/84

(43) Date of publication of application:
24.04.85 Bulletin 85/17

(45) Publication of the grant of the patent:
17.01.90 Bulletin 90/03

(84) Designated Contracting States:
DE NL

(56) References cited:
EP-A-0 024 526
EP-A-0 087 790
US-A-3 923 571
US-A-4 205 156

PATENT ABSTRACTS OF JAPAN, vol. 8, no. 71 (C-217)1508r, 3rd April 1984; & JP - A - 58 225 121 (SANYUREJIN K.K) 27-12-1983

The file contains technical information submitted after the application was filed and not included in this specification

(73) Proprietor: HITACHI, LTD.
6, Kanda Surugadai 4-chome Chiyoda-ku
Tokyo (JP)

(72) Inventor: Tanaka, Isamu
9-1, Awata-1-chome
Yokosuka-shi (JP)
Inventor: Kikuchi, Hiroshi
8-2, Ikego-2-chome
Zushi-shi (JP)
Inventor: Tomizawa, Akira
101-go, Suzukihaitsu 728-1, Shinbashicho
Totsuka-ku Yokohama (JP)
Inventor: Oka, Hitoshi
1905-125, Kamariyacho
Kanazawa-ku Yokohama (JP)

(74) Representative: Patentanwälte Beetz sen. - Beetz jun. Timpe - Siegfried - Schmitt-Fumian
Steinsdorfstrasse 10
D-8000 München 22 (DE)

(58) References cited:
PATENT ABSTRACTS OF JAPAN, vol. 6, no. 19 (C-90)897r, 3rd February 1982; & JP - A - 56 143 281 (SHIKOKU KASEI KOGYO K.K.) 07-11-1981

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 138 209 B1

(56) References cited:
**PATENT ABSTRACTS OF JAPAN, vol. 5, no. 45 (C-48)717r, 25th March 1981; & JP - A - 55 165 916 (SHIKOKU KASEI KOGYO K.K.) 24-12-1980**

**PATENT ABSTRACTS OF JAPAN, vol. 5, no. 148 (C-72)820r, 18th September 1981; & JP - A - 56 81333 (MATSUSHITA DENKI SANGYO K.K.) 03-07-1981**

**PATENT ABSTRACTS OF JAPAN, vol. 7, no. 7 (C-144)1152r, 12th January 1983; & JP - A - 57 164 118 (DAICEL K.K.) 08-10-1982**

## Description

This invention relates to epoxy resin compositions suitable for forming solder resists having resistance to electroless plating baths.

Formation of circuit patterns on substrates by electroless copper plating has been conducted, for example, by the following steps (1) to (5):

(1) Through-holes are formed in a double-side copper-clad laminate;

(2) $PdCl_2$ as a catalyst for nucleation of plating is coated;

(3) a circuit pattern is formed by etching;

(4) a resist layer is formed on portions other than the through-holes and lands, and

(5) electroless copper plating is conducted on the through-holes and the lands by immersing the laminate into a strongly alkaline electroless copper plating bath heated at 60 to 80°C with a pH of 12—13.

In such a process, when an epoxy resin composition comprising an epoxide compound, an epoxy-modified guanidine compound obtained by modifying 1-o-tolylbiguamide with an epoxy compound, a filler, a thixotropic agent, an organic solvent, and, if necessary, an anti-foaming agent is used for forming the resist (US—A—4 460 718 corresponding to EP—A—87790), the usable pot life (after mixing the major components and a hardener until screen printing of the composition) is as short as about 4 hours, and the time of preventing the resist from corrosion by the electroless copper plating bath is about 20 hours. Therefore, an improvement of the pot life and the resistance to an electroless plating bath has been desired.

JP—A—57-164 118 (Patent Abstracts of Japan, Vol. 7, No. 7 (C-44) [1152], 12th January, 1983) discloses a one-component resin composition comprising an alicyclic epoxy resin and dicyandiamide and a diaminotriazine-modified imidazole compound as a combined curing agent. The problem of soldering resistance is not dealt with in this document, and these compositions do not contain a phenolic compound.

It is an object of this invention to provide epoxy resin compositions suitable for use as soldering resists having excellent resistance to electroless plating baths and a usable pot life of as long as 40 hours or more.

The above object is achieved according to claim 1. The dependent claims relate to preferred embodiments.

The epoxy resin compositions according to the invention for use as plating resistant soldering resists comprise

(A) an epoxy compound having on an average more than one epoxy group per molecule,

(B) a curing agent,

(C) 3 to 40 parts of one or more fillers, and

(D) a thixotropic agent in such an amount that the resulting complete composition has a thixotropy index of 5 to 40 and a viscosity of 80 to 1000 Pa·s when measured using a B type rotational viscosimeter at a rotational speed of 1 $min^{-1}$ at 20°C, and are characterized by

— 100 parts by weight of component A,

— 1 to 20 parts by weight of a diaminotriazine-modified imidazole compound of formula I,

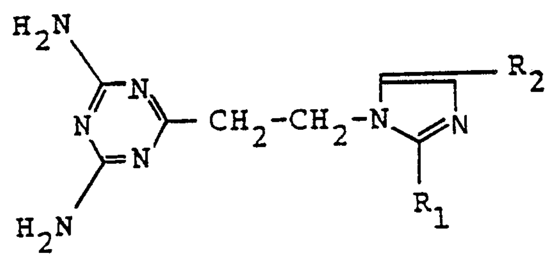

(I),

wherein $R_1$ is a $C_{1-20}$-alkyl or a phenyl group, and $R_2$ is H or a $C_{1-4}$-alkyl group, or of an acid adduct thereof, and

0,2 to 2,0 moles of dicyandiamide per mole of epoxy groups of component A as composite curing agent B,

0,5 to 10 parts by weight of an anti-foaming agent, and

0,1 to 8 parts by weight of a phenolic compound.

The epoxy resin composition of this invention is characterized by using as a special hardener the diaminotriazine-modified imidazole compound of formula I and dicyandiamide together with the phenolic compound and the anti-foaming agent.

According to an advantageous embodiment, when a thixotropic agent surface treated with silicone oil is used together with a phenolic compound, the performance is further improved.

As the epoxy compound having on the average more than one epoxy group per molecule, there can be used epoxide compounds having on the average — preferably more than two epoxy groups per molecule and being liquid at normal temperatures. Examples of the epoxy compounds are polyglycidyl ethers or polyglycidyl esters obtained by reacting epichlorohydrin with a polyhydric phenol such as bisphenol A, halogenated bisphenol A, bisphenol F, catechol, resorcinol or the like or a polyhydric alcohol such as glycerol or the like in the presence of a basic catalyst; epoxy novolaks obtained by condensing a novolak

type phenolic resin with epichlorohydrin; epoxidized polyolefins, epoxidized polybutadiene, or epoxidized vegetable oils, obtained by epoxidation by a peroxidation method; and the like. Commercially available such epoxy compounds are epoxy novolak resins such as DEN 431 (Dow Chemical Co., Ltd.), and Epikote 152 (Shell Chemical Co., Ltd.), bisphenol ether type epoxy resins such as Epikote 807, 828 (Shell Chemical Co., Ltd.), and bisphenol ester type epoxy resins such as Showdain 508 (Showa Denko Co., Ltd.). These epoxide compounds can be used alone or as a mixture thereof.

The diaminotriazine-modified imidazole compound of formula I or the acid adduct thereof and is hardly dissoluble in the epoxy compound A at normal temperatures. Therefore, the imidazole compound of the formula I or the acid adduct thereof has latent curing properties for the epoxy compound A.

The alkyl groups $R_1$ of formula I can be a straight-chain or branched chain alkyl groups. Preferable examples of such alkyl groups are $—CH_3$, $—C_2H_5$, $—CH(CH_3)_2$, $—C_4H_9$, $—C_5H_{11}$, $—C_6H_{13}$, $—C_7H_{15}$, $—C_8H_{17}$, $—C_9H_{19}$, $—C_{10}H_{21}$, $—C_{11}H_{23}$ and $—C_{17}H_{35}$. Alkyl groups $R_2$ preferably are methyl or ethyl.

Preferable examples of the imidazole compounds of formula I are:

2,4-diamino-6-(2′-methylimidazole-(1′))-ethyl-s-triazine;
2,4-diamino-6-(2′-ethyl-4′-methylimidazole-(1′))-ethyl-s-triazine;
2,4-diamino-6-(2′-undecylimidazole-(1′)-ethyl-s-triazine, and
2,4-diamino-6-(2′-methylimidazole-(1′))-ethyl-s-triazine·isocyanuric acid adduct.

The acid component used for forming an acid adduct of the imidazole compound of formula I includes methyl isocyanurate, ethyl isocyanurate, propyl isocyanurate and butyl isocyanurate.

The imidazole compounds of formula I can be used alone or as mixtures thereof.

The imidazole compounds of formula I or the acid adducts thereof are used in an amount of 1 to 20 parts by weight per 100 parts by weight of the epoxide compound A. If the amount is less than 1 part by weight, no effect is obtained. On the other hand, if the amount is more than 20 parts by weight, the resist film becomes soft, and is swollen and whitened when immersed in an electroless plating bath. Further, heat resistance of the resist film is lowered, and blisters are produced at the time of soldering.

The dicyandiamide is hardly dissoluble in the epoxy compound A at normal temperatures. Therefore, dicyandiamide has latent curing properties for the epoxide compound A.

Dicyandiamide is used in an amount of 0.2 to 2.0 moles per mole of epoxy groups of the epoxy compound A. When the amount is less than 0.2 mole, no effect is obtained as to the resistance to electroless plating bath. On the other hand, when the amount is more than 2.0 mole, dicyandiamide is released from the resist film when immersed in an electroless plating bath, which results in stopping the electroless plating reaction.

In this invention, it is necessary to use as component B both the imidazole compound of formula I, and dicyandiamide, as the hardener. When dicyandiamide is used alone as a hardener, although the pot life is long, printed circuit substrates are warped largely due to the high temperature (180°C or higher) necessary for the curing, which makes practical use impossible. On the other hand, when the imidazole compound of formula I is used alone as a hardener, the curing can be conducted at temperatures of 130°C or lower, which hardly involve the risk of warpage of a printed circuit substrate, but the adhesiveness to a copper foil is poor, and the resistance to electroless plating is lowered. It is very surprising that when the imidazole compound and dicyandiamide are used together, the above-mentioned disadvantages are overcome, and the usable pot life of the epoxy resin composition is remarkably prolonged.

As the filler of component C there can be used fine powders of talc, mica, alumina, barium sulfate, silica ($SiO_2$) and titanium oxide ($TiO_2$). These fillers can be used alone or as mixtures thereof. The average particle size of the filler is preferably 10 μm or less. The filler has the functions of improving the printing properties of the soldering resist and enhancing the mechanical properties of the resist film.

The filler is used in an amount of 3 to 40 parts by weight per 100 parts by weight of the epoxy compound A. When the amount is more than 40 parts by weight, the film forming properties become worse. On the other hand, when the amount is less than 3 parts by weight, there is no improvement of the properties.

The anti-foaming agent is effective for removing foams included at the time of printing the soldering resist. Examples of the anti-foaming agent are conventionally used silicone oils, more concretely, polyphenylsiloxanes, etc.

The anti-foaming agent is used in an amount of 0.5 to 10 parts by weight and preferably 0.5 to 5 parts by weight per 100 parts by weight of the epoxy compound A. When the amount is less than 0.5 part by weight, the anti-foaming effect is little while when the amount is more than 10 parts by weight, the resistance to electroless plating bath is lowered.

The thixotropic agent D is used for improving the printing properties of soldering resists. As the thixotropic agent, there can be used inorganic ultrafine powders of $SiO_2$, $Al_2O_3$, etc., having a particle size of 0.1 μm or less. These ultrafine powders of $SiO_2$ and $Al_2O_3$ can be surface treated with a surface treating agent such as a silicone oil.

The thixotropic agent is used in an amount sufficient to obtain a thixotropy index of the whole composition 5 to 40 and a viscosity of the whole composition of 800 to 10,000 poises when measured by using a B type rotational viscometer at a rotational speed of 1 $min^{-1}$ at 20°C.

The thixotropy index means the ratio of the viscosity measured at a rotational speed of 1 $min^{-1}$ ($\eta_1$) to the viscosity measured at a rotational speed of 100 $min^{-1}$ ($\eta_{100}$), i.e. $\eta_1/\eta_{100}$.

The phenolic compound is effective for further improving the pot life as compared with that of compositions without the phenolic compound because of mashing of amino groups of the hardeners components dissolved in the epoxy compound A. Examples of the phenolic compound are phenol, dihydric phenols such as catechol, resorcinol and hydroquinone, trihydric phenols such as pyrogallol, hydroxyhydroquinone, and phloroglucinol. These phenolic compounds can be used alone or as mixtures thereof.

The phenolic compound is used in an amount of 0.1 to 8 parts by weight per 100 parts by weight of the epoxy compound A. When the amount is less than 0.1 part by weight, there can be obtained no effect, while when the amount is more than 8 parts by weight, the soldering resist films obtained have inferior properties.

The epoxy resin compositions of this invention may further contain one or more colorants such as pigments (e.g., phthalocyanine blue or phthalocyanine green).

The above-mentioned components are kneaded in a mixing and grinding machine and further kneaded by using a three-roll mill to give a solventless one-component liquid type (100% solids, single component) soldering resist excellent in resistance to electroless plating baths. The resulting compositions have a very prolonged pot life, and the resist films obtained therefrom are excellent both in resistance to soldering and to electroless plating baths.

The invention is illustrated by way of the following Examples, in which all parts and percents are by weight unless otherwise specified.

## Example 1

| | |
|---|---|
| Epikote 807 (bisphenol F type epoxy resin, mfd. by Shell Chemical Co., Ltd., epoxy equivalent weight 170) | 100 parts |
| 2,4-Diamino-6-((2′-methylimidazole-(1′))-ethyl-s-triazine | 7 parts |
| Dicyandiamide | 8 parts |
| Talc powder L-1 (filler, average particle size 2 µm, mfd. by Nippon Talc Co., Ltd.) | 10 parts |
| Aerosil 200 (thixotropic agent, ultrafine powder of quartz, average particle size 0.016 µm, mfd. by Nihon Aerosil Co., Ltd.) | 3 parts |
| Aerosil C (thixotropic agent, ultrafine powder of alumina, average particle size 0.02 µm, mfd. by Nihon Aerosil Co., Ltd.) | 2 parts |
| Silicone oil SC-5540 (anti-foaming agent, mfd. by Toray Silicone Co. Ltd.) | 2 parts |
| Phthalocyanine green (colorant) | 1.5 parts |

The above-mentioned ingredients were kneaded by using a mixing and grinding machine, followed by sufficient kneading using a three-roll mill to give a solventless one-component liquid type soldering resist composition having a thixotropy index of 23 and a viscosity of 531 Pa·s (20°C, 1 $min^{-1}$). The composition showed a storage stability (usable time) of more than 30 days at 20°C.

The composition was printed by screen printing on a printed circuit substrate obtained by forming a pattern with a conductor of 0.3 to 20 mm width with spacings of 0.7 to 5 mm on a copper-clad epoxy-fiberglass substrate so as to expose the part of the conductor pattern. The soldering resist composition was cured in a furnace at 130°C for 30 min.

Then, the soldering resist coated printed circuit substrate was immersed for 40 h in an electroless copper plating bath having the following composition:

| | |
|---|---|
| $CuSO_4 \cdot 5H_2O$ | 13 g/l |
| EDTA·2Na* | 40 g/l |
| NaOH | 11.5 g/l |
| Polyethylene glycol stearylamine | 0.1 g/l |
| α,α'-Dipyridyl | 5 mg/l |
| Formalin (37%) | 3 ml/l |
| Water | ad 1 l |

Plating conditions:

| | |
|---|---|
| Plating temperature | 70°C |
| pH | 12.2 |

*EDTA·2Na = disodium ethylenediamine tetraacetate.

The plating bath was equipped with a device for automatically controlling the concentrations of the plating solution so as to make the concentrations of $Cu^{2+}$, formalin and EDTA·2Na and the pH constant.

Then, the substrate was taken out of the plating bath, washed with water and dried in a furnace at 80°C for 20 min.

The resulting soldering resist film did not exhibit color change such as whitening, swelling, blisters, and peeling from the substrate. The adhesive strength of the soldering resist film was evaluated by the cross-cut test wherein the resist film formed on the copper foil pattern was hatched with a sharp knife crosswisely with a pitch of 1 mm using a guide for the cross-cut test defined in Japanese Industrial Standard (JIS) K 5400, a pressure sensitive adhesive tape was applied to the hatched resist film and sticked sufficiently, the adhesive tape was removed at a strength under an angle of 45° from the resist film, and the peeling state of the cross-cut resist film was observed. No peeling of the resist film was detected. Therefore, the the adhesive strength of the resist film was evaluated as 10 points according to the cross-cut test evaluation table.

After subjecting the substrate to fluxing treatment, the substrate was placed in a solder bath heated at 260°C so that the soldering resist film was contacted with the solder for 20 s for testing the soldering heat resistance. No blisters nor cracks were detected on the soldering resist film.

When the cross-cut test was conducted on the resulting resist film, no peeling was detected, and the evaluated adhesive strength was 10 points according to JIS K 5400.

Example 2

Composition

| | |
|---|---|
| Epikote 807 | 100 parts |
| 2,4-Diamino-6-(2'-ethyl-4'-methylimidazole-(1'))-ethyl-s-triazine | 5 parts |
| Dicyandiamide | 5 parts |
| Alumina powder C (average particle size 1 µm, mfd. by Fujimi Kenma Kogyo K.K.) | 20 parts |
| Aerosil 200 | 3 parts |
| Aerosil C | 2 parts |
| Silicone oil SC-5540 | 2 parts |
| Phthalocyanine green | 1.5 parts |

The above-mentioned ingredients were kneaded in the same manner as described in Example 1 to give a solventless one-component liquid type soldering resist composition having a thixotropy index of 21 and a

viscosity of 430 Pa·s (20°C, 1 $min^{-1}$). The composition showed a storage stability of more than 30 days at 20°C.

A soldering resist film was formed by using the composition and evaluated in respect of the resistance to electroless plating bath and the soldering heat resistance in the same manner as described in Example 1. No abnormality such as color change, blisters, cracks, and peeling occurred on the soldering resist film. The evaluation result of the cross-cut test after soldering was 10 points.

Example 3

Composition:

| | |
|---|---|
| Epikote 807 | 100 parts |
| 2,4-Diamino-6-(2′-undecyl-imidazole-(1′))-ethyl-s-triazine | 5 parts |
| Dicyandiamide | 7 parts |
| Barium sulfate powder #300 (average particle size 0.8 μm, mfd. by Sakai Chemical Industry Co., Ltd.) | 35 parts |
| Aerosil 200 | 3 parts |
| Aerosil C | 2 parts |
| Silicone oil SC-5540 | 1 part |
| Phthalocyanine green | 1.5 parts. |

The above-mentioned ingredients were kneaded in the same manner as described in Example 1 to give a solventless one-component liquid type soldering resist composition having a thixotropoxy index of 20 and a viscosity of 532 Pa·s (20°C, 1 $min^{-1}$). The composition showed a storage stability of more than 30 days at 20°C.

A soldering resist film was formed by using the composition and evaluated in respect of the resistance to electroless plating bath and the soldering heat resistance in the same manner as described in Example 1. No abnormality such as color change, blisters, cracks and peeling occurred on the soldering resist film. The evaluation result of the cross-cut test after soldering was 10 points.

Example 4

Composition:

| | |
|---|---|
| Epikote 807 | 50 parts |
| Epikote 828 (bisphenol A type epoxy resin, mfd. by Shell Chemical Co., Ltd., epoxy equivalent weight 189) | 50 parts |
| 2,4-Diamino-6-(2′-methyl-imidazole-(1′)-ethyl-s-triazine·isocyanuric acid adduct | 5 parts |
| Dicyandiamide | 7 parts |
| Quartz powder, Crystalite VXX (average particle size 1 μm, mfd. by Tatsumori K.K.) | 10 parts |
| Aerosil RY 200 (ultrafine $SiO_2$ powder treated with silicone oil, mfd. by Nihon Aerosil Co., Ltd.) | 5 parts |
| Silicone oil SC-5400 | 2 parts |
| Phthalocyanine green | 1.5 parts |

The above-mentioned ingredients were kneaded in the same manner as described in Example 1 to give a solventless one-component liquid type soldering resist composition having a thixotropy index of 15 and a

viscosity of 634 Pa·s (20°C, 1 $min^{-1}$). The composition showed a storage stability of more than 30 days at 20°C.

A soldering resist film was formed by using the composition and evaluated in respect of the resistance to electroless plating bath and the soldering heat resistance in the same manner as described in Example 1. No abnormality such as color change, blisters, cracks and peeling occurred on the soldering resist film. The evaluation result of the cross-cut test after soldering was 10 points.

Example 5

Composition:

| | |
|---|---|
| Epikote 807 | 100 parts |
| 2,4-Diamino-6-(2'-methylimidazole-(1')-ethyl-s-triazine | 2.5 parts |
| Dicyandiamide | 7 parts |
| Pyrogallol | 0.5 part |
| Quartz powder, Crystalite VXX | 20 parts |
| Aerosil RY-200 surface treated with a silicone oil | 5 parts |
| Silicone oil SC-5540 | 2 parts |
| Phthalocyanine green | 1.5 parts |

The above-mentioned ingredients were kneaded in the same manner as described in Example 1 to give a solventless one-component liquid type soldering resist composition having a thixotropy index of 22 and a viscosity of 5520 poises (20°C, 1 $min^{-1}$). The storage stability of this soldering resist composition is represented in the attached drawing which shows diagrams of the storage time dependence of the thixotropy index and the viscosity of this composition. The curves prove a storage stability of 90 days and more at 20°C, since almost no change of the values of $\eta_1$, $\eta_{100}$ and $\eta_1/\eta_{100}$ (thixotropy index) was detected. Ten poises (P) are equivalent to one Pascal second (Pa·s). A soldering resist film was formed by using the composition and evaluated in respect of the resistance to electroless plating bath and the soldering heat resistance in the same manner as described in Example 1. No abnormality such as color change, blisters, cracks and peeling occurred on the soldering resist film. The evaluation result of the cross-cut test before and after soldering was 10 points in both cases.

As mentioned above, the epoxy resin compositions of this invention have an excellent storage stability (usable pot life) of more than 30 days and sometimes 90 days or more, excellent resistance to the electroless plating bath, that is, no abnormality of the solder resist such as degradation, color change such as whitening, swelling, blisters, peeling from the substrate, etc. occur, excellent printing properties, excellent adhesion to the substrate and conductors, and excellent soldering heat resistance.

## Claims

1. Epoxy resin compositions for use as plating resistant soldering resists on the basis of
(A) an epoxy compound having on an average more than one epoxy group per molecule,
(B) a curing agent,
(C) 3 to 40 parts of one or more fillers, and
(D) a thixotropic agent in such an amount that the resulting complete composition has a thixotropy index of 5 to 40 and a viscosity of 80 to 1000 Pa·s when measured using a B type rotational viscosimeter at a rotational speed of 1 $min^{-1}$ at 20°C, characterized by
— 100 parts by weight of component A,
— 1 to 20 parts by weight of a diaminotriazine-modified imidazole compound of formula I,

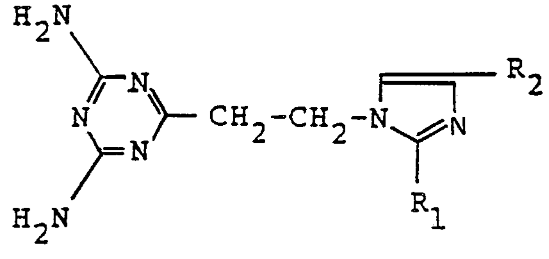

(I),

wherein $R_1$ is a $C_{1-20}$-alkyl or a phenyl group, and $R_2$ is H or a $C_{1-4}$-alkyl group, or of an acid adduct thereof, and

0,2 to 2,0 moles of dicyandiamide per mole of epoxy groups of component A as composite curing agent B,

0,5 to 10 parts by weight of an anti-foaming agent, and

0,1 to 8 parts by weight of a phenolic compound.

2. Epoxy resin compositions according to claim 1, characterized by an imidazole compound of formula I, wherein $R_1$ is methyl, ethyl, isopropyl, undecyl, heptadecyl or a phenyl group, and $R_2$ in formula I is hydrogen or methyl.

3. Epoxy resin compositions according to claim 1 or 2, characterized by 2,4-diamino-6-(2'-methylimidazole-(1'))-ethyl-s-triazine, 2,4-diamino-6-(2'-ethyl-4'-methylimidazole-(1'))-ethyl-s-triazine, 2,4-diamino-6-(2'-undecylimidazole-(1'))-ethyl-s-triazine or 2,4-diamino-6-(2'-methylimidazole-(1'))-ethyl-s-triazine isocyanurid acid adduct as imidazole compound of formula I.

4. Epoxy resin compositions according to one of claims 1 to 3, characterized by pyrogallol, resorcinol, catechol, hydroquinone, hydroxyhydroquinone, phloroglucinol or phenol as phenolic compound.

5. Epoxy resin compositions according to one of claims 1 to 4, characterized by an ultrafine powder of $SiO_2$ or $Al_2O_3$ surface treated with a silicone oil as thixotropic agent D.

6. Epoxy resin compositions according to one of claims 1 to 5, characterized by a silicone oil as anti-foaming agent and a thixotropic agent D surface treated with a silicone oil.

7. Epoxy resin compositions according to claim 6, characterized in that the silicone oil is a polyphenylsiloxane.

**Patentansprüche**

1. Epoxyharzmassen zur Verwendung als galvanisierbeständige Lötstoplacke auf der Basis von

(A) einer Epoxyverbindung mit im Mittel mehr als einer Epoxygruppe je Molekül,

(B) einem Härtungsmittel,

(C) 3 bis 40 Teilen eines oder mehrerer Füllstoffe und

(D) einem Thixotropiermittel in einer solchen Menge, daß die entstandene Masse einen Thixotropieindex von 5 bis 40 und eine Viskosität von 80 bis 1000 Pa·s bei Bestimmung in einem B-Rotations-Viskosimeter mit einer Drehgeschwindigkeit von 1 $min^{-1}$ bei 20°C hat, gekennzeichnet durch

— 100 Masseteile der Komponente (A),

— 1 bis 20 Masseteile eines diaminotriazin-modifizierten Imidazols der Formel (I)

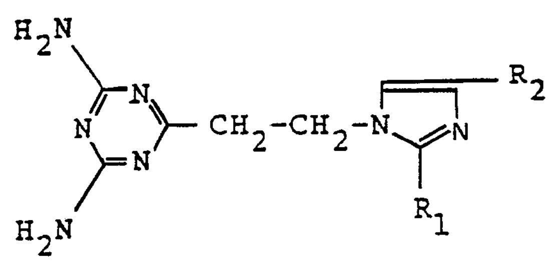

(I),

in der $R_1$ eine $C_{1-20}$-Alkyl- oder Phenylgruppe und

$R_2$ H oder eine $C_{1-4}$-Alkylgruppe ist,

oder eines seiner Säureaddukte, und

0,2 bis 2,0 mol Dicyandiamid je Mol Epoxygruppen der Komponente (A) als Verbundhärtungsmittel (B),

— 0,5 bis 10 Masseteile eines schaumverhindernden Mittels und

— 0,1 bis 8 Masseteile eines Phenols.

2. Epoxyharzmassen nach Anspruch 1, gekennzeichnet durch ein Imidazol der Formel (I), in der $R_1$ Methyl, Ethyl, Isopropyl, Undecyl, Heptadecyl oder Phenyl und $R_2$ Wasserstoff oder Methyl ist.

3. Epoxyharzmassen nach Anspruch 1 oder 2, gekennzeichnet durch 2,4-Diamino-6-(2'-methylimidazol-(1'))-ethyl-s-triazin, 2,4-Diamino-6-(2'-ethyl-4'-methylimidazol-(1'))-ethyl-s-triazin, 2,4-Diamino-6-(2'-undecylimidazol-(1'))-ethyl-s-triazin oder ein 2,4-Diamino-6-(2'-methylimidazol-(1'))-ethyl-s-triazin-isocyanursäure-Addukt als Imidazol der Formel (I).

4. Epoxyharzmassen nach einem der Ansprüche 1 bis 3, gekennzeichnet durch Pyrogallol, Resorcin, Catechin, Hydrochinon, Hydroxyhydrochinon, Phloroglucin oder Phenol als Phenol.

5. Epoxyharzmassen nach einem der Ansprüche 1 bis 4, gekennzeichnet durch in äußerst feines $SiO_2$— oder $Al_2O_3$— Pulver, das mit einem Silikonöl oberflächenbehandelt worden ist, als Thixotropiermittel (D).

6. Epoxyharzmassen nach einem der Ansprüche 1 bis 5, gekennzeichnet durch ein Silikonöl als schaumverhinderndes Mittel und ein mit einem Silikonöl oberflächenbehandeltes Thixotropiermittel (D).

7. Epoxyharzmassen nach Anspruch 6, dadurch gekennzeichnet, daß das Silikonöl ein Polyphenylsiloxan ist.

**Revendications**

1. Compositions de résine époxy utilisables comme vernis de soudure résistant au plaquage, à base de
(A) un composé époxy contenant en moyenne plus d'un groupe époxy par molécule,
(B) un agent durcisseur,
(C) 3 à 40 parties d'une ou de plusieurs charges, et
(D) un agent thixotrope en une proportion telle que la composition complete resultante présente un indice de thixotropie de 5 à 40 et une viscosite de 80 à 1000 Pa·s, mesurée au moyen d'un viscosimètre rotatif du type B, à une vitesse de rotation de 1 $min^{-1}$ à 20°C,
caractérisées en ce qu'elles contiennent
100 parties en poids de composant A,
1 à 20 parties en poids d'un composé imidazole-diaminotriazine modifié, de formule I,

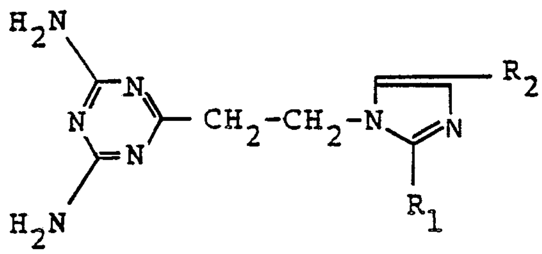

(I),

où $R_1$ est un groupe alkyle en $C_{1-20}$ ou un groupe phényle,
et $R_2$ est H ou un groupe alkyle en $C_{1-4}$,
ou un adduct acide de ces composés, et
0,2 à 2,0 moles de dicyandiamide par mole de groupes époxy du composant A, comme agent durcisseur composite B,
0,5 à 10 parties en poids d'un agent anti-mousse, et
0,1 à 8 parties en poids d'un composé phénolique.

2. Compositions de résine époxy selon la revendication 1, caractérisées en ce qu'elles contiennent un composé imidazole de formule I, où $R_1$ est un groupe méthyle, éthyle, isopropyle, undécyle, heptadécyle ou phényle, et $R_2$ de la formule I est un atome d'hydrogène ou un groupe méthyle.

3. Compositions de résine époxy selon la revendication 1 ou 2, caractérisées en ce qu'elles contiennent, comme composé imidazole de formule I la 2,4-diamino-6-(2'-methylimidazole-(1'))-ethyl-s-triazine, la 2,4-diamino-6-(2'-ethyl-4'-méthylimidazole-(1'))-éthyl-s-triazine, la 2,4-diamino-6-(2'-undécylimidazole-(1'))-éthyl-s-triazine ou l'adduct acide d'isocyanuride de la 2,4-diamino-6-(2'-méthylimidazole-(1'))-éthyl-s-triazine.

4. Compositions de résine époxy selon l'une quelconque des revendications 1 à 3, caractérisées en ce qu'elles contiennent, comme composé phénolique, le pyrogallol, le résorcinol, le catéchol, l'hydroquinone, l'hydroxyhydroquinone, le phloroglucinol ou le phénol.

5. Compositions de résine époxy selon l'une quelconque des revendications 1 à 4, caractérisées en ce qu'elles contiennent, comme agent thixotrope D, une poudre ultrafine de $SiO_2$ ou de $Al_2O_3$, traitée en surface par une huile de silicone.

6. Compositions de résine époxy selon l'une quelconque des revendications 1 à 5, caractérisées en ce qu'elles contiennent une huile de silicone comme agent anti-mousse et un agent thixotrope D, traitée en surface par une huile de silicone.

7. Compositions de résine époxy selon la revendication 6, caractérisées en ce que l'huile de silicone est un polyphénylsiloxane.

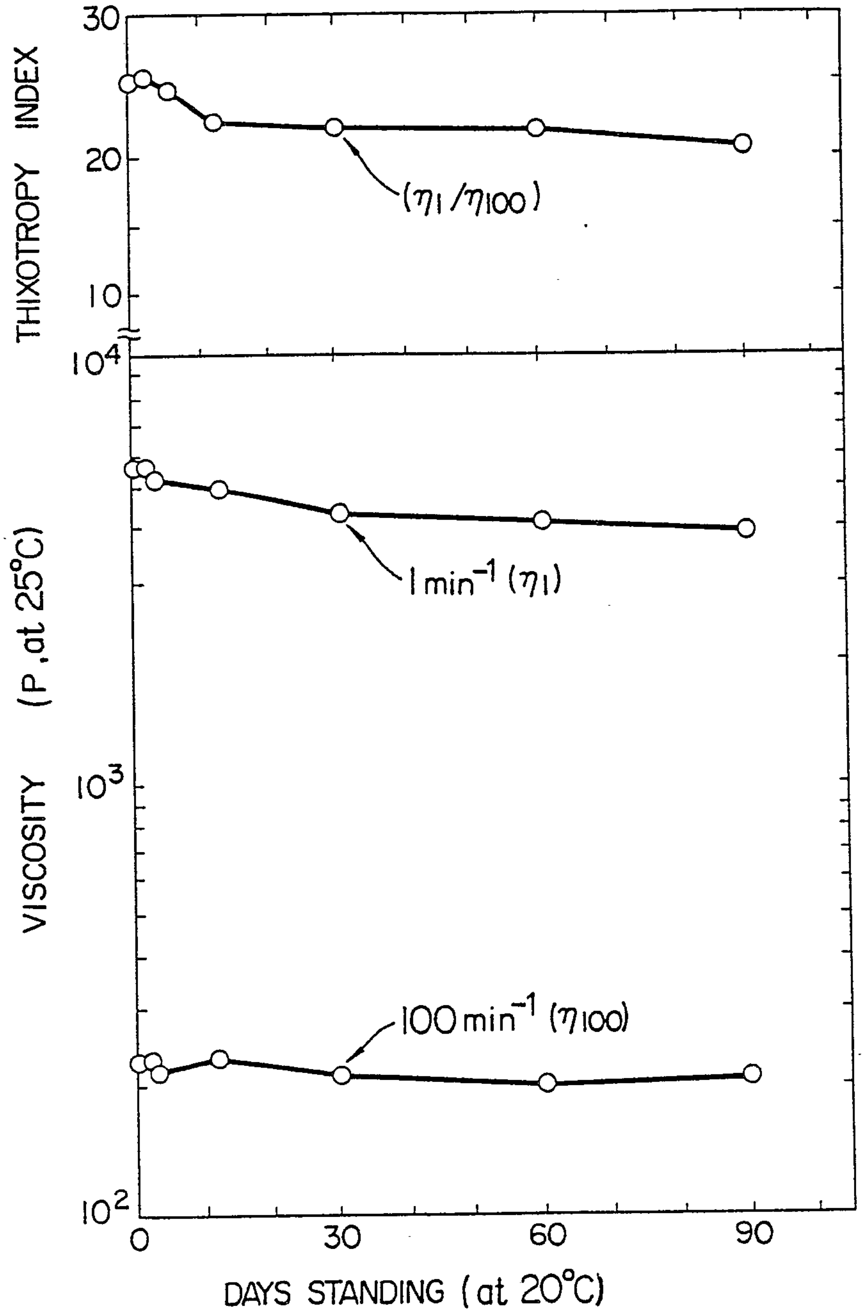
30
20
10
THIXOTROPY INDEX
($\eta_1$/$\eta_{100}$)
$10^4$
$10^3$
$10^2$
VISCOSITY (P, at 25°C)
1 $min^{-1}$ ($\eta_1$)
100 $min^{-1}$ ($\eta_{100}$)
0
30
60
90
DAYS STANDING (at 20°C)